(19)

Europäisches
Patentamt
European
Patent Office
Office européen
des brevets

(11)     EP 1 693 962 B1

(12)                     **EUROPEAN PATENT SPECIFICATION**

(45) Date of publication and mention
of the grant of the patent:
**16.07.2008  Bulletin 2008/29**

(51) Int Cl.:
**H03K 17/10** (2006.01)

(21) Application number: **06250861.9**

(22) Date of filing: **17.02.2006**

(54) **High voltage switching apparatus**

Hochspannungs-Schaltgerät

Appareil de commutation haute-tension

(84) Designated Contracting States:
**AT BE BG CH CY CZ DE DK EE ES FI FR GB GR
HU IE IS IT LI LT LU LV MC NL PL PT RO SE SI
SK TR**

(30) Priority: **18.02.2005  GB 0503439**

(43) Date of publication of application:
**23.08.2006  Bulletin 2006/34**

(73) Proprietor: **E2V Technologies (UK) Limited
Chelmsford, Essex CM1 2QU (GB)**

(72) Inventors:
• **Richardson, Robert
Chelmsford,
Essex CM3 5PQ (GB)**

• **Iskander, Stephen Mark
Chelmsford,
Essex CM1 1RU (GB)**

(74) Representative: **Sackin, Robert
Reddie & Grose
16 Theobalds Road
London WC1X 8PL (GB)**

(56) References cited:
**WO-A-02/103904          DE-A1- 19 815 957**

• **PATENT ABSTRACTS OF JAPAN vol. 010, no. 058
(E-386), 7 March 1986 (1986-03-07) & JP 60 210026
A (HITACHI SEISAKUSHO KK), 22 October 1985
(1985-10-22)**

**Description**

This invention relates to high voltage switching apparatus, and in particular, but not exclusively, to a switching apparatus for providing pulses to a pulse switched load.

Our WO 02 104 076 A describes a pulsed switching apparatus for an eht load such as a magnetron. A stack of FET switch modules are arranged in an oil-filled chamber surrounded by four capacitors which are mounted within a plastics housing. The switch stack receives an eht supply, typically at about -55kV and delivers a series of eht pulses to the magnetron. The switch also includes the various control circuitry which operates at lt voltages. This circuitry controls functions such as triggering of the FET switches.

In these devices, when the load is switched, it is desirable for the voltage to rise smoothly to the operating voltage. In practice, however, there is a tendency to a voltage overshoot. This is because the load is not a purely resistive load but is of a non-linear nature and includes a small capacitive component A known way of correcting for this voltage overshoot is to include a further capacitance in parallel with the load. The problem with this approach is that the added capacitance is large, typically in the order of 200pF, expensive and physically large.

Our International patent application WO 02/103904 solves this problem by distributing the load capacitance evenly across the switching modules. In one embodiment disclosed, each switching module has an identical capacitance nCd in parallel with the switch module where Cd is the required additional capacitance and n is the number of switching modules. The distribution of the load capacitance across the switching stack helps to swamp the effects of stray capacitances in the stack. It also allows relatively inexpensive capacitances to be used instead of a single expense load capacitor.

Although this arrangement is advantageous it does not give ideal performance.

A paper by G. Bredenkamp et al. "Transient Sharing in Series Coupled High Voltage Switches" (1991 Pulse Power Symposium) identifies a problem with unequal voltage sharing during high speed transience. It was already known to reduce overvoltage ratios by coupling a capacitor across each switch, which is often done to protect against overly high voltage/time gradients. Such capacitances are typically much lower than the distributed load capacitances of WO 02/103904. The Bredenkamp et al paper proposes that much smaller capacitances are coupled across the switches but with graded values which exactly compensate for the additional current drawn by the parasitic capacitances in each of the switches.

Although the prior art discussed above teaches the use of graded much smaller capacitances, we have appreciated that these capacitances may be combined with the distributed load capacitance to control the rise time of the switches. This is of particular advantage where the switching the arrangement is used to drive a magnetron although it also has advantages in other applications.

Accordingly, the present invention provides a high voltage switching arrangement for applying a pulse across a load, comprising a capacitor for providing electrical energy to the load, and a switch stack for connecting the capacitor to the load, the switch stack comprising a plurality of switches arranged in series, and a plurality of capacitances in parallel across the switches, wherein the parallel capacitances each comprise a distributed load component and a component to compensate for unequal voltage sharing during high transience, the compensation component being graded across the switches.

The load capacitance may be equal for each of the switches. This load capacitance may be equal to nCd, where Cd or the capacitance of the load, and n is the number of switches.

The load capacitance and graded capacitance components may comprise a single capacitor.

Groups of adjacent capacitors may have the same graded capacitance. These groups may comprise 3 or 5 capacitors.

An embodiment of the invention will now be described, by way of example and with reference to the accompanying drawings in which:

Fig 1. is a schematic longitudinal view of a high voltage switching mechanism;
Fig. 2 is a schematic cross-section on the line V-V in Figure 1; and
Fig 3 shows how the load capacitance may be distributed and include a graded element in accordance with an embodiment of the invention.

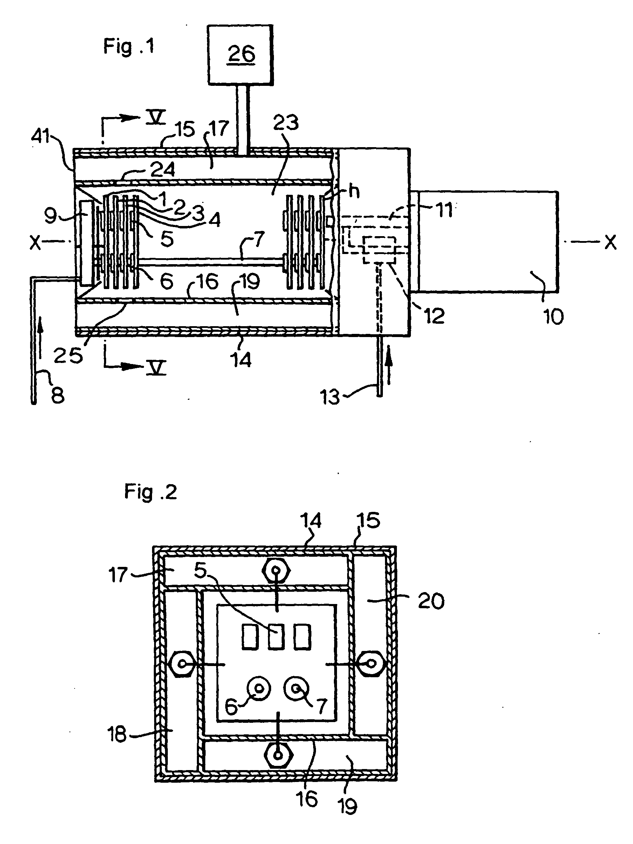

Figures 1 and 2 show the switching mechanism described in our earlier applications, GB 2298074.5 and GB 9928049.7. The mechanism provides high voltage pulses to a high voltage load, such as a magnetron, by switching a capacitance. The switching is triggered by trigger pulses derived from a high voltage supply and the capacitance is also charged by that supply.

The switching arrangement shown in Figures 1 and 2 comprises a switch stack arranged within a chamber surrounded by a plurality of capacitances. The switch stack comprises a number of FET modules 1, 2, 3, 4,... n, each of which includes one or more FET switches. There may be, for example, 75 FET modules in the stack and each module may include three FET switches. The modules are mounted in close proximity to one another and are stacked along the axis in Figure 1. As well as the FET switch, each module includes a secondary transformer winding 6 with a common primary winding 7 extending along the length of the axis to act as the primary for each module. The primary is to provide power to the FET switches. Power to the switching arrangement is applied from a source 8 to a trigger driver 9 at the high voltage end of the stack which is maintained at -55kV. The trigger driver is formed as a module of similar dimensions to the FET modules and forms the end module to the stack. The load 10, for example, a magnetron, is connected to an output 11 of the switching mechanism to receive pulses from the switching mechanism. The output 11 also provides an output 12 to a heater transformer for heating the magnetron cathodes. The power for the transformer is provided from a power source 13.

The switching mechanism is arranged within a housing 14. The housing is formed of a non-conductive material such as a plastics material and comprises outer and inner walls 15, 16 defining an annular chamber therebetween, and an interior chamber 23 bounded by the inner walls and in which the switching stack is arranged. The annular chamber and the interior chamber communicate via apertures 24, 25 in the inner wall 16.

As can be seen from Figure 2, the housing and the annular and interior chambers are rectangular in cross-section. Four capacitors 17, 18, 19, 20 are arranged in the annular chamber, one on each side, and extend along the length of the chamber shielding the switching mechanism. The capacitors are connected at the high voltage end of the first switch module and to the load 10 at the low voltage end, which may be at ground. The capacitors each comprise a plurality of parallel plates forming capacitor elements which are interconnected so that a nominally linear voltage gradient appears from the power end to the zero volt end. The capacitors may each be 0.15μF.

The unit is oil filled for heat dissipation and insulation. Oil can pass between the annular and inner chambers through passageways 24, 25. An expansion tank 26 is connected to the chambers which includes a diaphragm, and which moves with the changes in oil volume, for example due to temperature changes. The switching stack also comprises a control module 40 which is mounted on the stack between the trigger driver module and the first FET module 1 and which is of similar dimensions to the FET modules. The control module controls triggering of the FET switches and floats at the high voltage of -55kV but has its own it power supply to operate the control circuitry.

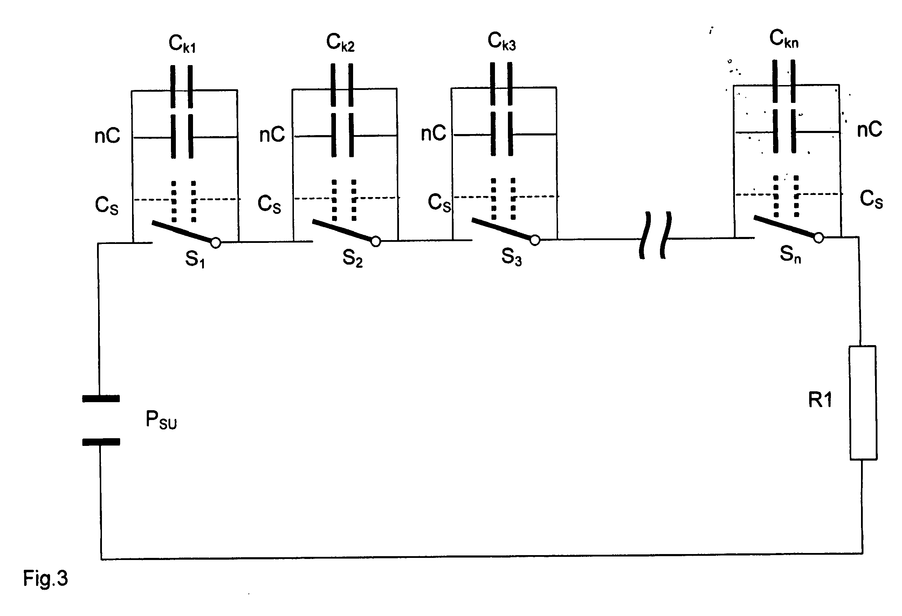

In the arrangement of Figure 3, embodying the invention, there is shown a number of switches S1, S2, S3 ... Sn. A typical switching apparatus contains a series of switch modules. In some cases about 75 switch modules. A capacitor is placed across each of the switch modules instead of a single capacitor across the load. In the prior art as shown in WO 02/103904 the value of each capacitor is nCd, where n is the number of switch modules or, effectively, the number of series connected capacitors. The value of nCd is such that the applied capacitance greatly exceeds and swamps any stray capacitances generated at the switch. The stray capacitance Cs is shown in phantom in Figure 3 as the effect is minimal compared to the effect of nCd.

The embodiment of the present invention, as shown in Figure 3, arranges a further capacitance Ck1-Ckn in parallel with the distributed load capacitances across each switching module. The value for Ck is different for each switching module and is determined by the formula:

$$C_k = \frac{[K^2 + K]}{2} \cdot C_b$$

Where K = N-1 where N is the module number, $C_k$ is the capacitance required across the module to compensate for unequal voltage sharing during high transience; and $C_s$ is the capacitance between the module and ground. For a switching module operating at 50kV, and having 10 switching modules, assuming a constant value of 42pF for $C_b$, the values of $C_k$ will vary from 0 to about 2nF across the stack.

Although shown as separate parallel capacitances in Figure 3, the capacitance of $C_k$ may be lumped together with the distributed load capacitances nCd so that there is a graded reduction in the load capacitances down the stack. This arrangement achieves near perfect sharing and retains the benefit of the distribution of the load capacitance.

In an application such as the 75 module example described above, it is not necessary that 75 difference capacitors are used. It is possible to grade using groups of capacitors of the same value, for example groups of 3 or 5.

Various modifications to the embodiments described are possible and will occur to those skilled in the art without departing from the scope of the invention which is defined solely by the following claims.

**Claims**

1. A high voltage switching arrangement for applying a pulse across a load (R1), comprising a capacitor for providing electrical energy to the load (R1) and a switch stack for connecting the capacitor to the load, the switch stack comprising a plurality of switches (Sn) arranged in series, and a plurality of capacitances in parallel across the switches, wherein the parallel capacitances each comprise a distributed load component (nC) and a component (Ckn) to compensate for unequal voltage sharing during high transience, the compensation component (Ckn) being graded across the switches.

2. A switching arrangement according to claim 1, wherein the distributed load capacitance is equal for each of the switches.

3. A switching arrangement according to claim 2, wherein the load capacitance is equal to nCd where Cd is the capacitance of the load and n is the number of switches.

4. A switching arrangement according to any preceding claim wherein the load capacitance component and the graded compensation component comprise a single capacitor.

5. A switching arrangement according to any of claims 1 to 4, wherein the value of the graded component is given by:

$$C_K = \frac{[K^2 + K]}{2} \cdot C_b$$

6. A switching arrangement according to any preceding claim wherein the value of the graded component is different for each switch in the stack.

7. A switching arrangement according to any of claims 1 to 5 wherein the graded components are grouped together whereby groups of adjacent capacitors have the same graded component value.

8. A switching arrangement according to claim 7, wherein the groups of capacitors comprise 3 or 5 capacitors.

**Patentansprüche**

1. Hochspannungsschaltanordnung zum Anlegen eines Impulses über eine Last (R1), die einen Kondensator zum Zuführen von elektrischer Energie zu der Last (R1) und einen Switch-Stack zum Verbinden des Kondensators mit der Last umfasst, wobei der Switch-Stack mehrere in Reihe angeordnete Schalter (Sn) und mehrere Kapazitanzen parallel über die Schalter umfasst, wobei die parallelen Kapazitanzen jeweils eine verteilte Lastkomponente (nC) und eine Komponente (Ckn) zum Kompensieren einer ungleichen Spannungsverteilung bei hoher Transienz umfasst, wobei die Kompensationskomponente (Ckn) über die Schalter gradiert wird.

2. Schaltanordnung nach Anspruch 1, wobei die verteilte Lastkapazitanz für alle Schalter gleich ist.

3. Schaltanordnung nach Anspruch 2, wobei die Lastkapazitanz gleich nCd ist, wo Cd die Kapazitanz der Last und n die Anzahl der Schalter ist.

4. Schaltanordnung nach einem der vorherigen Ansprüche, wobei die Lastkapazitanzkomponente und die gradierte Kompensationskomponente einen einzelnen Kondensator umfassen.

5. Schaltanordnung nach einem der Ansprüche 1 bis 4, wobei der Wert der gradierten Komponente ausgedrückt wird durch:

$$C_K = \frac{[K^2 + K]}{2} \cdot C_b$$

6. Schaltanordnung nach einem der vorherigen Ansprüche, wobei sich der Wert der gradierten Komponente für jeden Schalter in dem Stack unterscheidet.

7. Schaltanordnung nach einem der Ansprüche 1 bis 5, wobei die gradierten Komponenten zusammen gruppiert werden, so dass Gruppen von benachbarten Kondensatoren denselben gradierten Komponentenwert haben.

8. Schaltanordnung nach Anspruch 7, wobei die Gruppen von Kondensatoren 3 oder 5 Kondensatoren umfassen.

**Revendications**

1. Agencement de commutation à haute tension pour appliquer une impulsion aux bornes d'une charge (R1), comprenant un condensateur pour fournir une énergie électrique à la charge (R1) et une pile de commutateurs pour connecter le condensateur à la charge, la pile de commutateurs comprenant une pluralité de commutateurs (Sn) agencés en série, et une pluralité de capacités en parallèle aux bornes des commutateurs, où les capacités parallèles comprennent chacun un composant de charge répartie (nC) et un composant (Ckn) pour compenser un partage de tension inégal durant un effet transitoire important, le composant de compensation (Ckn) étant gradué aux bornes des commutateurs.

2. Agencement de commutation selon la revendication 1, dans lequel la capacité de charge répartie est égale pour chacun des commutateurs.

3. Agencement de commutation selon la revendication 2, dans lequel la capacité de charge est égale à nCd où Cd est la capacité de la charge et n est le nombre de commutateurs.

4. Agencement de commutation selon l'une quelconque des revendications précédentes, dans lequel le composant de capacité de charge et le composant de compensation gradué comprennent un condensateur unique.

5. Agencement de commutation selon l'une quelconque des revendications 1 à 4, dans lequel la valeur du composant gradué est donnée par :

$$C_K \; = \; \frac{[K^2 + K]}{2}.C_b$$

6. Agencement de commutation selon l'une quelconque des revendications précédentes, dans lequel la valeur du composant gradué est différente pour chaque commutateur dans la pile.

7. Agencement de commutation selon l'une quelconque des revendications 1 à 5, dans lequel les composants gradués sont groupés ensemble de telle sorte que des groupes de composants adjacents aient la même valeur de composant gradué.

8. Agencement de commutation selon la revendication 7, dans lequel les groupes de condensateurs comprennent 3 ou 5 condensateurs.

EP 1 693 962 B1

Fig .1

Fig .2

Fig.3

**REFERENCES CITED IN THE DESCRIPTION**

**Patent documents cited in the description**

- WO 02104076 A
- WO 02103904 A
- GB 2298074 A
- GB 9928049 A